# EUROPÄISCHE PATENTSCHRIFT

(11) **EP 0 439 656 B1**
(45) Veröffentlichungstag und Bekanntmachung des Hinweises auf die Patenterteilung: **16.05.2001**
(21) Anmeldenummer: 90101925.7
(22) Anmeldetag: 31.01.1990
(51) Int. Cl.: H01L 23/66

(54) **Chipträger für ein Mikrowellen-Halbleiterbauelement**
Chip support for a microwave semiconductor device
Support de chip pour un module semi-conducteur à micro-ondes

(43) Veröffentlichungstag der Anmeldung: 07.08.1991
(73) Patentinhaber: Infineon Technologies AG, 81669 München (DE)
(72) Erfinder: Zimmermann, Walter, Ing.grad., D-8250 Dorfen (DE)
(74) Vertreter: Zedlitz, Peter, Dipl.-Inf.

(56) Entgegenhaltungen:
- EP-A- 0 026 788
- EP-A- 0 419 709
- GB-A- 1 175 122
- JP-A- 58 142 576
- PATENT ABSTRACTS OF JAPAN vol. 9, no. 263 (E-351)(1986) 19 Oktober 1985, & JP-A-60 109254 (HITACHI SEISAKUSHO) 14 Juni 1985,
- PATENT ABSTRACTS OF JAPAN vol. 10, no. 268 (E-436)(2324) 12 September 1986, & JP-A-61 90454 (NEC CORP) 08 Mai 1986,
- PATENT ABSTRACTS OF JAPAN vol. 11, no. 108 (E-495)(2555) 04 April 1987, & JP-A-61 255041 (MITSUBISHI ELECTRIC CORP) 12 November 1986,
- PATENT ABSTRACTS OF JAPAN vol. 12, no. 174 (E-612)(3021) 24 Mai 1988, & JP-A-62 281458 (TOSHIBA CORP) 07 Dezember 1987,

## Beschreibung

Die Erfindung betrifft ein Mikrowellen-Halbleiterbauelement mit einem Chipträger.

Ein Chipträger für Mikrowellen-Halbleiterbauelemente soll eine auch oberhalb von 12GHz geeignete Kapselung der Mikrowellen-Halbleiterbauelemente unter Wahrung der MikrowellenEigenschaften des Halbleiterbauelements und bei gleichzeitig weitgehender Unterdrückung von Rück-/Überkopplungen und undefinierter Impedanzen eine Aufrechterhaltung der Stabilität (Schwingungsunterdrückung) ermöglichen.

Ein Chipträger soll für oberflächenmontierbare Mikrowellen-Halbleiterbauelemente geeignet sein.

Ein Chipträger soll ein günstiges Phasenverhalten S11 sowie ein günstiges Rückwirkungsverhalten S12 sowie geringe Gehäuseverluste ermöglichen.

Ein Chipträger soll auch bei Verwendung eines Plastikgehäuses mindestens gleich günstige Eigenschaften ermöglichen, wie sie bei einem Mikrowellen-Halbleiterbauelement in einem Keramikgehäuse erzielt werden.

Der vorliegenden Erfindung liegt die Aufgabe zugrunde, Ein Mikrowellen-Halbleiterbauelement mit vier elektrischen Anschlüssen, die auf zwei Längsseiten einer Kunststoffumhüllung herausragen, anzugeben, das bei einer kompakter Bauweise ein günstiges Betriebsund Anwendungsverhalten ermöglicht.

Diese Aufgabe wird erfindungsgemäß durch nach dem Patentanspruch 1 gelöst.

Ausgestaltungen und Vorteile der Erfindung sind in den Unteransprüchen, der Beschreibung und der Zeichnung angegeben.

Die Erfindung ermöglicht erhebliche Verbesserungen im Phasenverhalten S11 sowie im Rückwirkungsverhalten S12 sowie niedrige Gehäuseverluste. Die Erfindung ermöglicht auch oberhalb von 12GHz eine Verwendung eines Plastikgehäuses, das mindestens ein Betriebs- und Anwendungsverhalten ermöglicht, wie es mit einem Mikrowellen-Halbleiterbauelement in einem Keramikgehäuse, z.B. CEREC-70, erzielt werden kann.

Ein Mikrowellen-Halbleiterbauelement nach der Erfindung ist insbesondere für SMD (Surface mounted device)-Bauelemente geeignet. Ein Mikrowellen-Halbleiterbauelement nach der Erfindung ist insbesondere für ein SOT143-Bauelement geeignet. Ein Mikrowellen-Halbleiterbauelement nach der Erfindung ist insbesondere auch für ein Mini-SOT-Bauelement geeignet.

Ein Mikrowellen-Halbleiterbauelement nach der Erfindung ist für die für CEREC-70-Gehäuse üblichen breitbandigen Anpaßschaltungen geeignet.

Ein Mikrowellen-Halbleiterbauelement nach der Erfindung kann so ausgestaltet sein, daß er zum CEREC-70-Gehäuse PIN-kompatibel ist.

Ein Mikrowellen-Halbleiterbauelement nach der Erfindung ist insbesondere für ein HEMT(High electron mobility transistor)-Bauelement geeignet. Ein Mikrowellen-Halbleiterbauelement nach der Erfindung ist auch für sonstige Mikrowellen-Bauelemente geeignet.

Ein Mikrowellen-Halbleiterbauelement nach der Erfindung ermöglicht ein MikrowellenBauelement, das gegenüber Anwenderschaltungen unempfindlich reagiert, insbesondere gegenüber Source-Erdungen, wie sie durch unterschiedliche Leiterplatten-Materialien gegeben sind.

Der diagonale Massesteg zwischen den beiden externen Source-Elektroden ermöglicht bei einem Mikrowellen-Halbleiterbauelement nach der Erfindung den kürzest möglichen Gate-Anschluß nach außen bei gleichzeitiger Unterbringung der Source-Kontakte. Die geometrische und elektrische Länge zwischen externem Gate-Anschluß und Halbleiterchip wird vorteilhaft auf ein Minimum reduziert. Die Gate-Anschlüsse des Halbleiterchips werden vorteilhaft möglichst kurz kontaktiert und nach Möglichkeit auch doppelt kontaktiert. Der Source-Anschluß des Halbleiterchips wird vorteilhaft vierfach und ebenfalls mit möglichst kurzen Bonddrähten kontaktiert. Die Gate-Elektrode des Chipträgers ist vorteilhaft verbreitert. Eine Verankerung der Gate-Elektrode und/oder der Drain-Elektrode des Chipträgers in einer Plastikumhüllung des Bauelements mittels Haken und/oder mindestens einem Durchbruch werden vorteilhafterweise so gestaltet, daß sie elektrisch nicht nachteilig wirken.

Die Source-Gegenkopplung durch den Steg im Gehäuse ist gering wegen der geringen Dielektrizitätskonstante der Plastikmasse der Umhüllung des Bauelements. Damit ist die innere Verkopplung des Gate-Anschlusses und des Drain-Anschlusses des Bauelements über den Source-Steg mit den ihrerseits geringen Endkapazitäten ebenfalls gering.

Die Gate-Elektrode ist dort, wo sie dem Steg am nächsten benachbart ist, schräg angeschnitten. Dadurch wird eine kürzere Laufzeit der Mikrowellen ermöglicht.

Vorteilhafterweise ist die Gate-Elektrode dem Steg so dicht wie möglich benachbart. Dabei sind jedoch Endkapazitäten, Streuungen und Toleranzen für Stanzwerkzeuge zu berücksichtigen. Eine nach heutigen Erkenntnissen sinnvolle Größe für einen sehr kleinen Abstand zwischen Gate-Elektrode und Steg ist ungefähr 0,1mm.

Die externen Anschlüsse des Mikrowellen-Halbleiterbauelements weisen vorteilhafterweise einen für Anwender brauchbaren Arbeitsabstand auf, damit keine Lotbrücken zwischen benachbarten externen Anschlüssen entstehen. Eine sinnvolle Größe für einen solchen Abstand zwischen zwei benachbarten externen Anschlüssen ist beispielsweise 0,6mm. Diese Abstände zwischen benachbarten externen Anschlüssen können bei zunehmender Miniaturisierung verkleinert werden.

Ein Mini-SOT-Gehäuse hat einen kürzeren Plastikkörper als ein SOT143-Gehäuse (in der Längsrichtung). Auch für einen solchen Plastikkörper ist ein Chipträger nach der Erfindung verwendbar.

Wenn der Halbleiterchip schräg zur Längsachse bzw. zur Querachse des Chipträgers aufgesetzt wird, kann der Weg von der Gate-Elektrode zum Halbleiterchip-Gate-Anschluß verkürzt werden. Dadurch ist eine kürzere Länge der Kontaktierdrähte möglich.

Ein Bauelement mit einem Chipträger nach der Erfindung ist anwenderfreundlich und ermöglicht eine geringe Phasendrehung vom externen Gate-Anschluß und Drain-Anschluß zum Halbleiterchip hin.

Ein Mikrowellen-Halbleiterbauelement nach der Erfindung ermöglicht in einfacher Weise eine Vierfach-Kontaktierung zwischen Halbleiterchip und Source-Elektrode. Ein Mikrowellen-Halbleiterbauelement nach der Erfindung ermöglicht in einfacher Weise eine Zweifach-Kontaktierung zwischen Halbleiterchip und Drain-Elektrode. Ein Mikrowellen-Halbleiterbauelement nach der Erfindung ermöglicht in einfacher Weise eine Zweifach-Kontaktierung zwischen Halbleiterchip und Gate-Elektrode.

Ein Mikrowellen-Halbleiterbauelement nach der Erfindung ermöglicht bessere Ergebnisse für einen HEMT als ein Keramik-Gehäuse. Ein Mikrowellen-Halbleiterbauelement nach der Erfindung ist in der Anpaßbarkeit mindestens vergleichbar mit einem Keramikgehäuse.

Der externe Gate-Anschluß ist vorteilhafterweise breiter als der externe Drain-Anschluß. Ein günstiges Maß für die Breite des externen Gate-Anschlusses liegt zwischen etwa 0,5mm und 0,8mm.

Vorteilhafterweise wird die Drain-Elektrode so nahe wie möglich am Steg in Richtung zum Halbleiterchip hin angeordnet. Dadurch werden kurze Kontaktierdrähte und ein kurzer Weg für die Mikrowellen ermöglicht.

Die Drain-Elektrode kann einfach oder doppelt kontaktiert sein. Die Gate-Elektrode kann einfach, doppelt oder vierfach kontaktiert sein. Die Source-Elektrode kann einfach, doppelt oder vierfach kontaktiert sein.

Der Anschluß zwischen Halbleiterchip und Gate-Elektrode ist vorteilhafterweise so kurz wie möglich. Der Anschluß zwischen Halbleiterchip und Gate-Elektrode ist vorteilhafterweise wellenwiderstandsmäßig niederohmig zum externen Gehäuse-Anschluß geführt.

Zur Verankerung der Gate-Elektrode bzw. der Drain-Elektrode in einer später aufzubringenden Umhüllung des MikrowellenBauelements werden vorteilhafterweise Nasen und/oder Durchbrüche in den betreffenden Elektroden vorgesehen. Dadurch ergibt sich eine gute mechanisch stabile Verankerung dieser Elektroden im Plastikkörper des Bauelements.

Ein Mikrowellenbauelement mit einem Chipträger nach der Erfindung ist SMD-fähig. Ein solches SMD-Mikrowellenbauelement mit einem solchen SMD-Gehäuse erfüllt Mikrowelleneigenschaften zumindest in befriedigender Weise.

Die verschiedenen Anschlüsse (Pads) auf dem Halbleiterchip für Source, Drain und Gate können in beliebiger Weise auf diesem Halbleiterchip angeordnet sein. Dadurch kann es ermöglicht werden, daß auch bei einer geraden Anordnung des Halbleiterchips bezüglich Längsachse bzw. Querachse des Chipträgers günstige Mikrowelleneigenschaften erzielt werden.

Ein Mikrowellenbauelement mit einem Chipträger nach der Erfindung besitzt günstige Vierpol-S-Parameter. Ein Mikrowellenbauelement mit einem Chipträger nach der Erfindung ermöglicht eine geringe Phasendrehung bei S11. Ein Mikrowellenbauelement mit einem Chipträger nach der Erfindung ermöglicht eine Phase von fast 180°.

Vorteilhafterweise wird der Halbleiterchip auf dem Steg so nahe wie möglich an die Gate-Elektrode angeordnet.

Die Erfindung wird im folgenden anhand der Zeichnung näher erläutert.

Figuren 1 bis 7 erläutern verschiedene Versionen eines Chipträgers nach der Erfindung bzw. eines Mikrowellenbauelements mit einem Chipträger nach der Erfindung.

Figur 8 zeigt ein SMD-Mikrowellenbauelement mit einem Chipträger nach der Erfindung.

Figur 9 zeigt das Phasenverhalten S11 eines Mikrowellenbauelements mit einem Chipträger nach der Erfindung.

Figur 10 zeigt Vierpol-S-Parameter für ein Mikrowellenbauelement mit einem Chipträger nach der Erfindung.

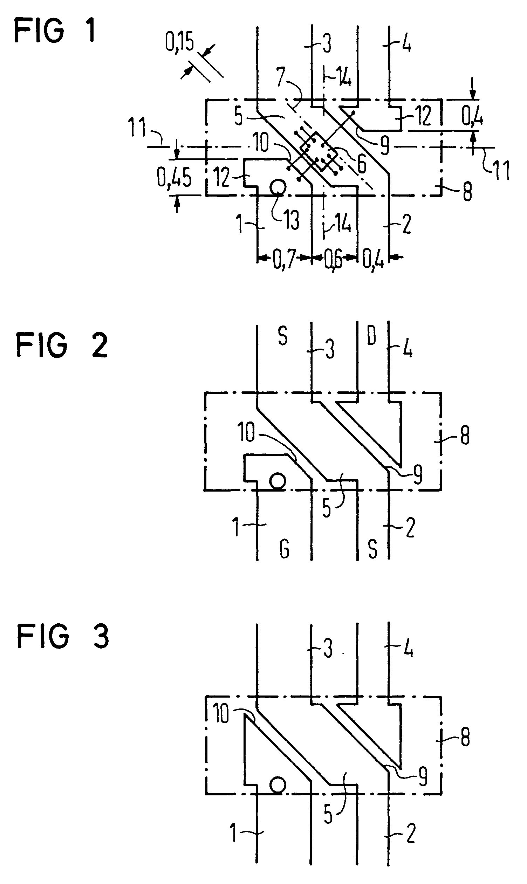

Figuren 1 bis 7 erläutern verschiedene Chipträger bzw. Mikrowellenbauelemente mit einem Chipträger. Gleiche Teile sind dabei mit gleichen Bezugszeichen versehen. In der Zeichnung sind jeweils nur Chipträger mit vier externen elektrischen Anschlüssen dargestellt. Die Erfindung ist jedoch auch geeignet für Chipträger mit mehr als vier externen elektrischen Anschlüssen, z.B. für ein MMIC-Mikrowellenbauelement. Ein Chipträger nach der Zeichnung besitzt einen externen Gate-Anschluß 1, zwei externe Source-Anschlüsse 2, 3 und einen externen Drain-Anschluß 4. Der externe Gate-Anschluß 1 und ein externer Source-Anschluß 2 befinden sich auf einer Seite des Chipträgers. Der andere externe Source-Anschluß 3 und der externe Drain-Anschluß 4 befinden sich auf einer dieser Seite des Chipträgers gegenüberliegenden Seite des Chipträgers. Der Chipträger besitzt eine Längsachse 11 und eine Querachse 14. Die beiden externen Source-Anschlüsse 2, 3 befinden sich sowohl auf gegenüberliegenden Seiten der Längsachse 11 als auch auf gegenüberliegenden Seiten der Querachse 14. Die Achse 14 des Chipträgers definiert eine geometrische Linie, die auf einer Seite des Chipträgers zwischen dem externen Gate-Anschluß 1 und dem externen Source-Anschluß 2 und die auf der gegenüberliegenden Seite des Chipträgers zwischen dem anderen externen Source-Anschluß 3 und dem externen Drain-Anschluß 4 verläuft. Die beiden externen Source-Anschlüsse 2, 3 sind einstückig über den Steg 5 miteinander verbunden. Der Steg 5 verläuft im wesentlichen schräg zur Achse (geometrischen Linie) 14. Innerhalb des Steges 5 kann eine Mittellinie definiert werden, die die Mittellinie des externen Source-Anschlusses 2 mit der Mittellinie des externen Source-Anschlusses 3 verbindet. Diese Mittellinie 7 innerhalb des Steges 5 verläuft im wesentlichen schräg zur Achse (geometrischen Linie) 14. Günstig ist es, wenn der Steg 5 im wesentlichen unter einem Winkel von 45° zur Achse (geometrischen Linie) 14 verläuft. Die Kontaktierdrähte zwischen Halbleiterchip 6 und Gate-Elektrode sollen so kurz wie möglich sein. Aus diesem Grunde besitzt die Gate-Elektrode dort, wo sie dem Steg 5 am nächsten benachbart ist, eine schräge Berandung 10. Diese schräge Berandung 10 verläuft günstigerweise ebenfalls unter einem Winkel von 45° zur Achse (geometrischen Linie) 14. Der Halbleiterchip 6 ist ebenfalls schräg zur Achse (geometrischen Linie) 14 angeordnet. Der Halbleiterchip 6 ist der Gate-Elektrode so eng wie möglich benachbart. Die Achsen des Halbleiterchips weisen einen Winkel von 45° zur Achse (geometrischen Linie) 14 auf. Auch die Drain-Elektrode ist dem Steg 5 eng benachbart. Auch die Drain-Elektrode weist dort, wo sie dem Steg am nächsten benachbart ist, eine Berandung 9, die schräg zur Achse (geometrischen Linie) 14 verläuft, auf.

Ein Mikrowellenbauelement mit einem Chipträger ist mit einer Umhüllung 8 versehen. Die Umhüllung 8 kann der Umhüllung eines SOT143-Gehäuses entsprechen. Wenn die der Umhüllung eines SOT143-Gehäuses entsprechende Umhüllung 8 an beiden Enden (bezüglich der Achse 11) verkürzt wird, erhält man die Umhüllung eines Mini-SOT-Gehäuses.

Der externe Gate-Anschluß 1 ist breiter ausgeführt als der externe Drain-Anschluß 4. Um eine mechanisch stabile Verankerung des Chipträgers in der Umhüllung 8 zu ermöglichen und um elektrische Nachteile zu vermeiden, besitzt die Gate-Elektrode einen Durchbruch 13 und eine Nase 12 und besitzt die Drain-Elektrode ebenfalls eine Nase 12.

Im Ausführungsbeispiel besitzen der externe Gate-Anschluß 1 eine Breite von 0,7mm und der externe Drain-Anschluß 4 eine Breite von 0,4mm. Der externe Gate-Anschluß 1 besitzt einen Abstand zum externen Source-Anschluß 2 von 0,6mm. Die Gate-Elektrode besitzt einen Abstand zum Steg 5 entlang der Berandung 10 von 0,15mm. Die der Achse 11 am nächsten benachbarte Berandung der Gate-Elektrode besitzt zum Rand der Umhüllung 8 einen nächsten Abstand von 0,45mm. Die der Achse 11 am nächsten benachbarte Berandung der Drain-Elektrode besitzt zum Rand der Umhüllung 8 einen nächsten Abstand von 0,4mm.

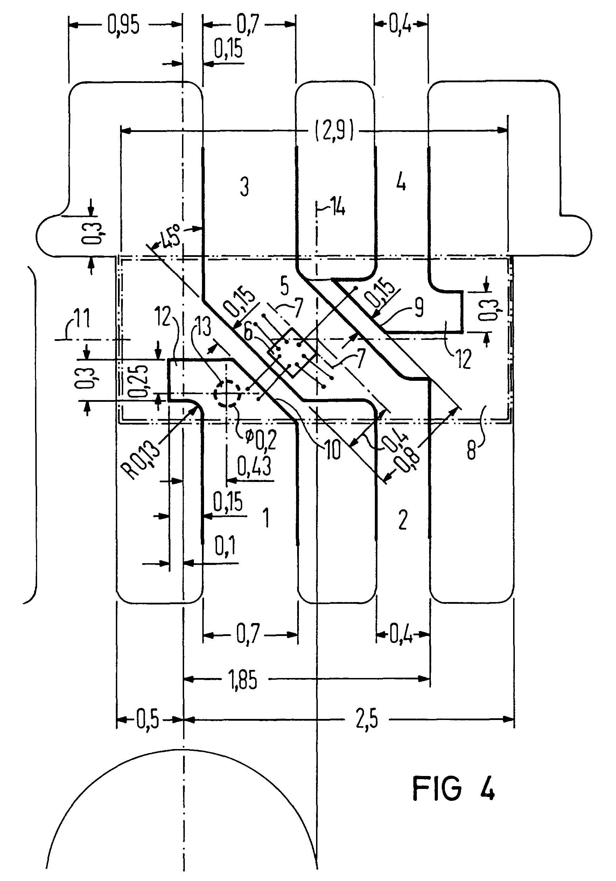

FIG 4 zeigt einen Chipträger, bei dem die Berandungen der Gate-Elektrode, der Drain-Elektrode und des Steges 5 optimiert worden sind. Dabei müssen beispielsweise die gegenüberliegenden Berandungen des Steges 5 nicht notwendig parallel zueinander verlaufen. Es genügt, wenn der Steg 5 im wesentlichen schräg zur Achse (geometrischen Linie) 14 verläuft.

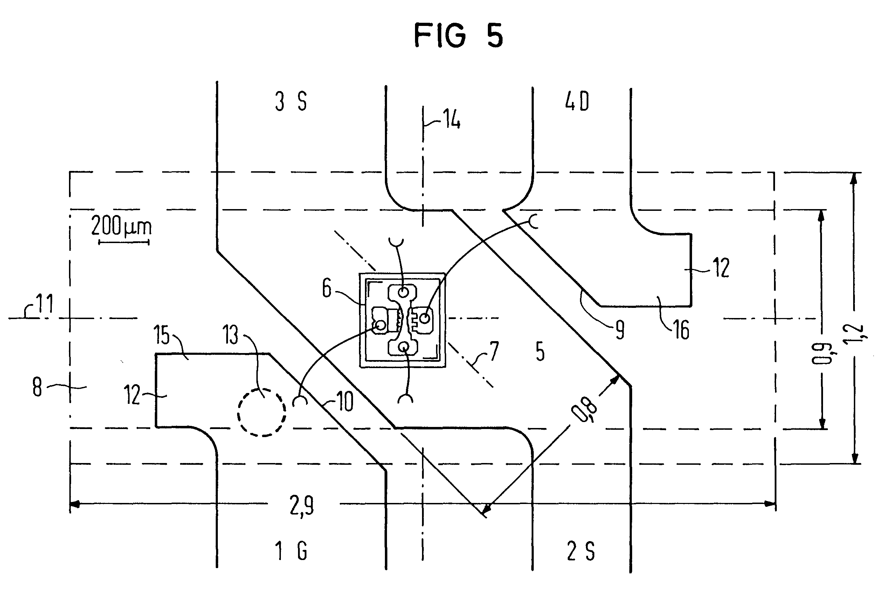

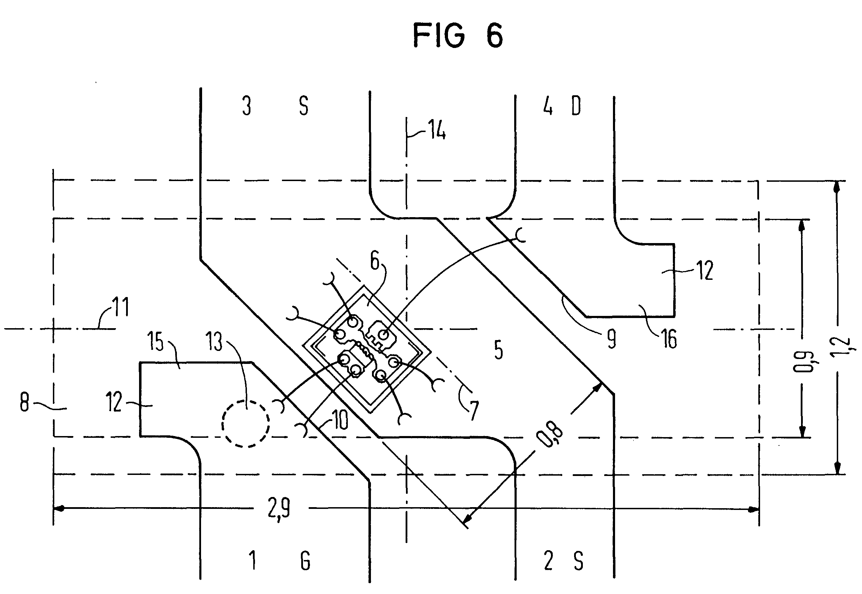

Figur 5 zeigt ein Mikrowellenbauelement mit einem Chipträger, bei dem der Halbleiterchip 6 so angeordnet ist, daß seine Kanten parallel zu den Achsen 11, 14 verlaufen. Ein solches Mikrowellenbauelement ist beispielsweise für eine Verwendung bei 8GHz brauchbar. Für eine Verwendung bei höheren Frequenzen, beispielsweise bei 12GHz, ist jedoch eine schräge Anordnung des Halbleiterchips 6 bezüglich der Achsen 11, 14 gemäß FIG 6 vorzuziehen.

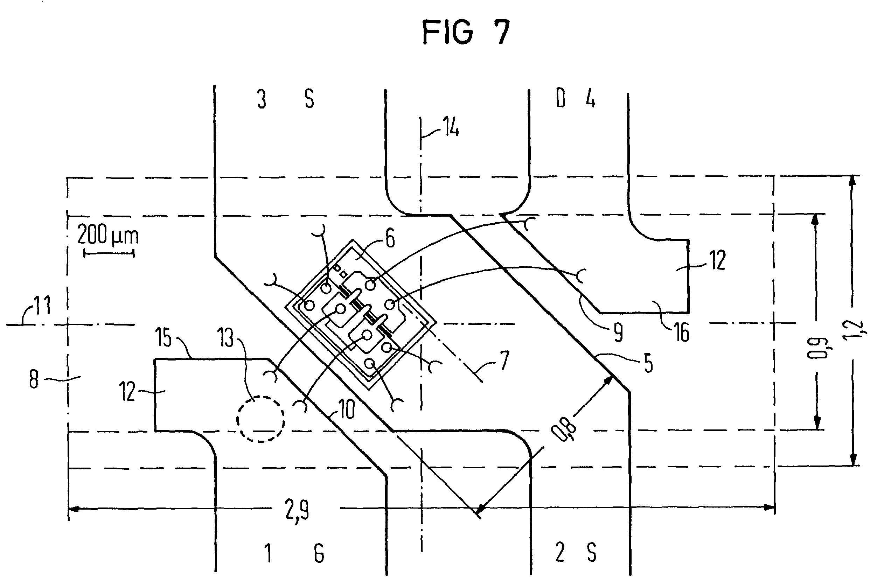

FIG 7 zeigt ein Mikrowellenbauelement mit einem Chipträger, bei dem der Halbleiterchip 6 schräg bezüglich der Achsen 11, 14 angeordnet ist. Der Halbleiterchip 6 ist doppelt mit der Gate-Elektrode, doppelt mit der Drain-Elektrode und vierfach mit der Source-Elektrode kontaktiert.

Ein Vergleich von FIG 4 mit FIG 7 zeigt, daß bei einem Mikrowellenbauelement nach FIG 4 die Kontaktierdrähte zwischen Gate-Elektrode und Halbleiterchip 6 und zwischen Halbleiterchip 6 und Drain-Elektrode kürzer sind als bei einem Mikrowellenbauelement nach FIG 7.

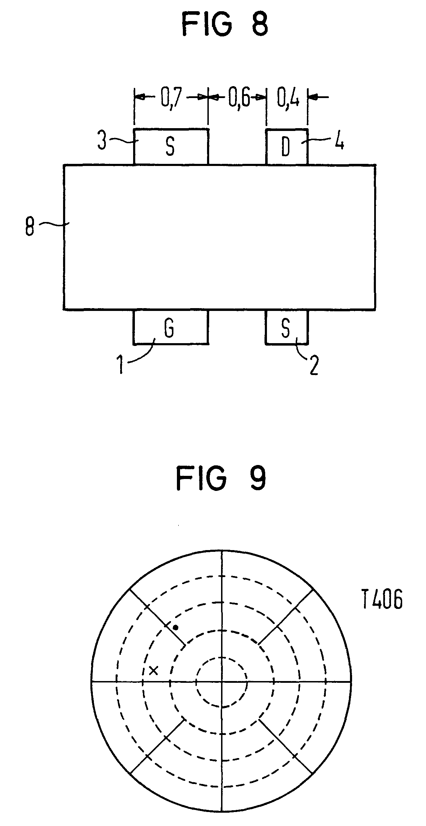

FIG 8 zeigt die äußeren Abmessungen eines 12GHz-GaAs-Mikrowellen-Bauelements in einem SMD-Plastik-Gehäuse. Bei Verwendung für einen HEMT erhält man bei einer Frequenz von 12 GHz, einer Spannung VDS von 2V und einem Strom ID von 12mA eine Rauschzahl F/dB/typ von 1.3 und einen Gewinn bei Rauschanpassung Gass/dB/typ von 10.5. Bei Verwendung eines Mikrowellenbauelements mit einem Chipträger für einen GaAs-Feldeffekttransistor erhält man bei einer Frequenz von 12GHz, einer Spannung VDS von 3V und einem Strom ID von 15mA eine Rauschzahl F/dB/typ von 1.8 und einen Gewinn bei Rauschanpassung Gass/dB/typ von 8.5.

FIG 9 zeigt das Phasenverhalten S11 eines Mikrowellenbauelements mit einem Chipträger mit einer Plastik-Umhüllung in einem SOT143-Gehäuse bei einer Frequenz von 12GHz. Dabei ist der Halbleiterchip vierfach mit der Source-Elektrode kontaktiert. Der Punkt zeigt den Wert für das Phasenverhalten S11 bei Einfachkontaktierung des Halbleiterchips mit der Gate-Elektrode. Das Kreuz zeigt den Wert für das Phasenverhalten S11 bei einer doppelten Kontaktierung des Halbleiterchips mit der Gate-Elektrode.

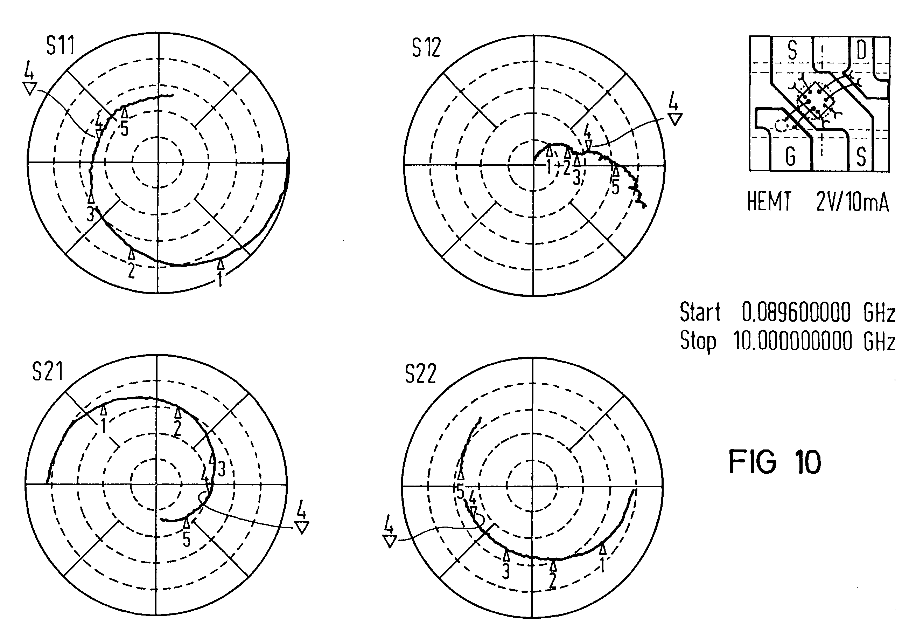

FIG 10 zeigt die verschiedenen Vierpol-S-Parameter für ein Mikrowellenbauelement mit einem Chipträger, bei dem ein HEMT als Halbleiterchip vierfach mit der Source-Elektrode, doppelt mit der Drain-Elektrode und doppelt mit der Gate-Elektrode kontaktiert ist. Die Markierung mit der Nummer 4 entspricht dabei jeweils einer Frequenz von 12GHz.

Ein Chipträger nach der Erfindung kann vielfach modifiziert werden. Beispielsweise kann der gesamte Chipträger bezüglich der Achse 11 gespiegelt werden. Dann sind die externen Anschlüsse 1 und 3 und die externen Anschlüsse 2 und 4 jeweils mit einander vertauscht. Beispielsweise kann der gesamte Chipträger bezüglich der Acnse 14 gespiegelt werden. Dann sind die externen Anschlüsse 1 und 2 und die externen Anschlüsse 3 und 4 jeweils miteinander vertauscht. Beispielsweise können auch die Berandungen des Steges 5 und/oder der Gate-Elektrode 15 und/oder der Drain-Elektrode 16 variiert werden.

## Patentansprüche

1. Mikrowellen-Halbleiterbauelement,
das ein Halbleiterchip (6), einen Chipträger mit mindestens vier externen elektrischen Anschlüssen, nämlich einem ersten und einem zweiten externen Source-Anschluß (2, 3), einem externen Gate-Anschluß (1) und einem externen Drain-Anschluß (4), und eine Kunststoffumhüllung (8) aufweist, bei dem
der erste externe Source-Anschluß (2) und der externe Gate-Anschluß (1) aus einer ersten Längsseite der Kunststoffumhüllung (8) herausragen,
der zweite externe Source-Anschluß (3) und der externe Drain-Anschluß (4) aus einer der ersten Längsseite der Kunststoffumhüllung (8) gegenüberliegenden zweiten Längsseite der Kunststoffumhüllung (8) herausragen,
sowohl der erste und der zweite externe Source-Anschluß (2, 3) als auch der externe Gate-Anschluß (1) und der externe Drainanschluß (4) jeweils in Richtung der Längsmittelachse (11) der Kunststoffumhüllung (8) seitlich versetzt angeordnet sind, derart, daß in der Draufsicht auf den Chipträger eine gerade Linie (14) so angeordnet werden kann, daß sie sowohl zwischen dem ersten externen Sourceanschluß (2) und dem externen Gate-Anschluß (1) als auch zwischen dem zweiten externen Source-Anschluß (3) und dem externen Drain-Anschluß (4) verläuft und daß der externe Gate-Anschluß (1) und der externe Drain-Anschluß (4) auf verschiedenen Seiten der geraden Linie (14) liegen, wobei die grade Linie (14) quer zur Längsmittelachse (11) verläuft und
der erste externe Source-Anschluß (2) und der zweite externe Source-Anschluß (3) einstückig über einen Steg (5), auf dem das Halbleiterchip (6) befestigt ist, miteinander verbunden sind, wobei der Steg (5) im wesentlichen schräg zur Linie (14) verläuft und
wobei der externe Gate-Anschluß (1) im Innern der Kunststoffumhüllung (8) schräg zur Längsmittelachse seines außerhalb der Kunststoffumhüllung (8) liegenden Teilstückes angeschnitten ist, derart, daß die zugehörige Schnittfläche (10) parallel zur nächstliegenden Seitenfläche des Steges (5) liegt und zumindest zwei Längsmittelachsen der außerhalb der Kunststoffumhüllung (8) liegenden Teilstücks des ersten und des zweiten externen Source-Anschlusses (2, 3), des externen Gate-Anschlusses (1) und des externen Drain-Anschlusses (4) parallel zur geraden Linie (14) verlaufen.

2. Mikrowellen-Halbleiterbauelement nach Anspruch 1,
**dadurch gekennzeichnet,** daß der externe Drain-Anschluß (1) im Innern der Kunststoffumhüllung (8) schräg zur Längsmittelachse seines außerhalb der Kunststoffumhüllung liegenden Teilstückes angeschnitten ist, derart, daß die zugehörige Schnittfläche (9) in einem Abstand parallel zur nächstliegenden Seitenfläche des Steges (5) liegt.

3. Mikrowellen-Halbleiterbauelement nach Anspruch 1 oder 2,
**dadurch gekennzeichnet,** daß die Längsmittelachsen der außerhalb der Kunststoffumhüllung liegenden Teilstücke des ersten und des zweiten externen Source-Anschlusses (2, 3), des externen Gate-Anschlusses (1) und des externen Drain-Anschlusses (4) in einer gemeinsamen Ebene liegen.

4. Mikrowellen-Halbleiterbauelement nach einem der Ansprüche 1 bis 3,
**dadurch gekennzeichnet,** daß die Längsmittelachsen der außerhalb der Kunststoffumhüllung (8) liegenden Teilstücke des ersten externen Source-Anschlusses (2) und des externen Drain-Anschlusses (4) auf einer gemeinsamen geraden Linie liegen.

5. Mikrowellen-Halbleiterbauelement nach einem der Ansprüche 1 bis 4,
**dadurch gekennzeichnet,** daß die Längsmittelachsen der außerhalb der Kunststoffumhüllung (8) liegenden Teilstücke des zweiten externen Source-Anschlusses (3) und des externen Gate-Anschlusses (1) auf einer gemeinsamen geraden Linie liegen.

6. Mikrowellen-Halbleiterbauelement nach einem der Ansprüche 1 bis 5,
**dadurch gekennzeichnet,** daß mindestens eine Seitenfläche des Steges (5) die Längsmittelachse (11) der Kunststoffumhüllung (8) unter einem Winkel von 45° schneidet.

7. Mikrowellen-Halbleiterbauelement nach einem der Ansprüche 1 bis 6,
**dadurch gekennzeichnet,** daß das Halbleiterchip (6) derart auf dem Steg (5) befestigt ist, daß eine Seitenfläche parallel zu einer Seitenfläche des Steges (5) liegt.

8. Mikrowellen-Halbleiterbauelement nach einem der Ansprüche 1 bis 7,
**dadurch gekennzeichnet,** daß der externe Gate-Anschluß (1) breiter als der externe Drain-Anschluß (4) ist.

9. Mikrowellen-Halbleiterbauelement nach einem der Ansprüche 1 bis 8,
**dadurch gekennzeichnet,** daß der zweite externe Source-Anschluß (3) breiter als der externe Drain-Anschluß (4) ist.

10. Mikrowellen-Halbleiterbauelement nach einem der Ansprüche 1 bis 9,
**dadurch gekennzeichnet,** daß der externe Gate- (1) und/oder Drain-Anschluß (4) mit wenigstens einer Einrichtung (12, 13) zur stabilen Verankerung in der Kunststoffumhüllung (8) versehen ist.

11. Mikrowellen-Halbleiterbauelement nach einem der Ansprüche 1 bis 10,
**dadurch gekennzeichnet,** daß das Halbleitersteg (6) mit mindestens vier Bonddrähten mit dem Steg (5) verbunden ist.

12. Mikrowellen-Halbleiterbauelement nach einem der Ansprüche 1 bis 11,
**dadurch gekennzeichnet,** daß das Halbleiterchip (6) mit mindestens zwei Bonddrähten mit dem externen Drain-Anschluß (4) verbunden ist.

13. Mikrowellen-Halbleiterbauelement nach einem der Ansprüche 1 bis 12,
**dadurch gekennzeichnet,** daß die Umhüllung (8) eine SMD-Kunsstoffumhüllung ist.

## Claims

1. Microwave semiconductor device, which has a semiconductor chip (6), a chip support with at least four external electrical terminals, namely a first and a second external source terminal (2, 3), an external gate terminal (1) and an external drain terminal (4), and a plastic encapsulation (8), in which
the first external source terminal (2) and the external gate terminal (1) project from a first longitudinal side of the plastic encapsulation (8),
the second external source terminal (3) and the external drain terminal (4) project from a second longitudinal side of the plastic encapsulation (8), which is opposite to the first longitudinal side of the plastic encapsulation (8),
both the first and the second external source terminal (2, 3) and the external gate terminal (1) and the external drain terminal (4) are in each case arranged laterally offset in the direction of the longitudinal central axis (11) of the plastic encapsulation (8), in such a way that, in the plan view of the chip support, a straight line (14) can be arranged such that it runs both between the first external source terminal (2) and the external gate terminal (1) and between the second external source terminal (2) and the external drain terminal (4) and that the external gate terminal (1) and the external drain terminal (4) lie on different sides of the straight line (14), the straight line (14) running transversely with respect to the longitudinal central axis (11), and
the first external source terminal (2) and the second external source terminal (3) are connected to one another integrally via a web (5), on which the semiconductor chip (6) is fixed, the web (5) running essentially obliquely with respect to the line (14), and
the external gate terminal (1), inside the plastic encapsulation (8), being initially cut obliquely with respect to the longitudinal central axis of its portion lying outside the plastic encapsulation (8), in such a way that the associated cut face (10) lies parallel to the nearest side face of the web (5) and that at least two longitudinal central axes of those portions, lying outside the plastic encapsulation (8), of the first and of the second external source terminal (2, 3), of the external gate terminal (1) and of the external drain terminal (4) run parallel to the straight line (14).

2. Microwave semiconductor device according to Claim 1,
characterized in that the external drain terminal (1), inside the plastic encapsulation (8), is initially cut obliquely with respect to the longitudinal central axis of its portion lying outside the plastic encapsulation, in such a way that the associated cut face (9) lies at a distance from and parallel to the nearest side face of the web (5).

3. Microwave semiconductor device according to Claim 1 or 2,
characterized in that the longitudinal central axes of those portions, lying outside the plastic encapsulation, of the first and of the second external source terminal (2, 3), of the external gate terminal (1) and of the external drain terminal (4) lie in a common plane.

4. Microwave semiconductor device according to one of Claims 1 to 3,
characterized in that the longitudinal central axes of those portions, lying outside the plastic encapsulation (8), of the first external source terminal (2) and of the external drain terminal (4) lie on a common straight line.

5. Microwave semiconductor device according to one of Claims 1 to 4,
characterized in that the longitudinal central axes of those portions, lying outside the plastic encapsulation (8), of the second external source terminal (3) and of the external gate terminal (1) lie on a common straight line.

6. Microwave semiconductor device according to one of Claims 1 to 5,
characterized in that at least one side face of the web (5) intersects the longitudinal central axis (11) of the plastic encapsulation (8) at an angle of 45°.

7. Microwave semiconductor device according to one of Claims 1 to 6,
characterized in that the semiconductor chip (6) is fixed on the web (5) in such a way that a side face lies parallel to a side face of the web (5).

8. Microwave semiconductor device according to one of Claims 1 to 7,
characterized in that the external gate terminal (1) is wider than the external drain terminal (4).

9. Microwave semiconductor device according to one of Claims 1 to 8,
characterized in that the second external source terminal (2) is wider than the external drain terminal (4).

10. Microwave semiconductor device according to one of Claims 1 to 9,
characterized in that the external gate terminal (1) and/or drain terminal (4) is provided with at least one facility (12, 13) for stable anchoring in the plastic encapsulation (8).

11. Microwave semiconductor device according to one of Claims 1 to 10,
characterized in that the semiconductor chip (6) is connected to the web (5) by at least four bonding wires.

12. Microwave semiconductor device according to one of Claims 1 to 11,
characterized in that the semiconductor chip (6) is connected to the external drain terminal (4) by at least two bonding wires.

13. Microwave semiconductor device according to one of Claims 1 to 12,
characterized in that the encapsulation (8) is an SMD plastic encapsulation.

## Revendications

1. Composant à semiconducteur micro-ondes,
qui comprend une puce (6) à semiconducteur, un support de puce ayant au moins quatre bornes électriques extérieures, à savoir une première et une deuxième home (2, 3) de source extérieures, une borne (1) de grille extérieure, et une home (4) de drain extérieure, et une enveloppe (8) en matière plastique, dans lequel
la première home (2) de source extérieure et la home (1) de grille extérieure font saillie d'un premier côté longitudinal de l'enveloppe (8) en matière plastique,
la deuxième home (3) de source extérieure et la home (4) de drain extérieure font saillie d'un deuxième côté longitudinal de l'enveloppe (8) en matière plastique, opposé au premier côté longitudinal de l'enveloppe (8) en matière plastique,
tant la première et la deuxième bornes (2, 3) de source extérieure que la borne (1) de grille extérieure et la home (4) de drain extérieure sont décalées latéralement respectivement en direction de l'axe (11 ) médian longitudinal de l'enveloppe (8) en matière plastique, de sorte que, dans la vue en plan, il peut être traçé sur le support de puce une ligne (14) droite de manière qu'elle passe aussi bien entre la première home (2) de source extérieure et la première home (1) de grille extérieure qu'entre la deuxième home (3) de source extérieure et la home (4) de drain extérieure et de façon que la home (1) de grille extérieure et la home (4) de drain extérieure se trouvent sur des côtés différents de la ligne (14) droite, la ligne (14) droite s'étendant transversalement à l'axe (11) longitudinal médian et la première borne (2) de source extérieure et la deuxième borne (3) de source extérieure étant reliées entre elles d'une pièce par l'intermédiaire d'une nervure (5) sur laquelle la puce (6) à semiconducteur est fixée, la nervure (5) s'étendant essentiellement de manière inclinée par rapport à l'axe ou à la ligne (14) et la borne (1) de grille extérieure est entaillée à l'intérieur de l'enveloppe (8) en matière plastique de manière inclinée par rapport à l'axe longitudinal médian de sa partie se trouvant à l'extérieur de l'enveloppe (8) en matière plastique de façon que la surface (10) d'entaille associée soit parallèle à la surface latérale la plus proche de la nervure (5) et de façon qu'au moins deux axes longitudinaux médians de la partie, se trouvant à l'extérieur de l'enveloppe (8) en matière plastique, de la première et de la deuxième borne (2, 3) de source extérieure de la borne (1) de grille extérieure et de la borne (3) de drain extérieur s'étendent parallèlement à la ligne (14) droite.

2. Composant à semiconducteur micro-ondes suivant la revendication 1, caractérisé en ce que la borne (1) de drain extérieure est entaillée à l'intérieur de l'enveloppe (8) en matière plastique de manière inclinée par rapport à l'axe longitudinal médian de sa partie se trouvant à l'extérieur de l'enveloppe en matière plastique, de façon que la surface (9) d'entaille associée se trouve à distance de la surface latérale la plus proche de la nervure (5) en lui étant parallèle.

3. Composant à semiconducteur micro-ondes suivant la revendication 1 ou 2, caractérisé en ce que les axes longitudinaux médians des parties se trouvant à l'extérieur de l'enveloppe en matière plastique de la première et de la deuxième borne (2, 3) de source extérieure, de la borne (1) de grille extérieure et de la borne (4) de drain extérieure sont dans un plan commun.

4. Composant à semiconducteur micro-ondes suivant l'une des revendications 1 à 3, caractérisé en ce que les axes longitudinaux médians des parties, se trouvant à l'extérieur de l'enveloppe (8) en matière plastique, de la première borne (2) de source extérieure et de la borne (4) de drain extérieure sont sur une ligne droite commune.

5. Composant à semiconducteur micro-ondes suivant l'une des revendications 1 à 4, caractérisé en ce que les axes longitudinaux médians des parties, se trouvant à l'extérieur de l'enveloppe (8) en matière plastique, de la deuxième borne (3) de source extérieure et de la borne (1) de grille extérieure sont sur une ligne droite commune.

6. Composant à semiconducteur micro-ondes suivant l'une des revendications 1 à 5, caractérisé en ce qu'au moins une surface latérale de la nervure (5) coupe l'axe (11) longitudinal médian de l'enveloppe (8) en matière plastique sous un angle de 45°.

7. Composant à semiconducteur micro-ondes suivant l'une des revendications 1 à 6, caractérisé en ce que la puce (6) à semiconducteur est fixée sur la nervure (5) de façon à ce qu'une surface latérale soit parallèle à une surface latérale de la nervure (5).

8. Composant à semiconducteur micro-ondes suivant l'une des revendications 1 à 7, caractérisé en ce que la home (1) de grille extérieure est plus large que la borne (4) de drain extérieur.

9. Composant à semiconducteur micro-ondes suivant l'une des revendications 1 à 8, caractérisé en ce que la deuxième borne (3) de source extérieure est plus large que la borne (4) de drain extérieure.

10. Composant à semiconducteur micro-ondes suivant l'une des revendications 1 à 9, caractérisé en ce que la borne (1) extérieure et/ou la borne (4) de drain sont munies au moins d'un dispositif (12, 13) d'ancrage stable dans l'enveloppe (8) en matière plastique.

11. Composant à semiconducteur micro-ondes suivant l'une des revendications 1 à 6, caractérisé en ce que la nervure (6) semiconductrice est reliée à la nervure (5) par au moins quatre fils de liaison.

12. Composant à semiconducteur micro-ondes suivant l'une des revendications 1 à 11, caractérisé en ce que la puce (6) à semiconducteur est reliée à la borne (4) de drain extérieure par au moins deux fils de liaison.

13. Composant à semiconducteur micro-ondes suivant l'une des revendications 1 à 12, caractérisé en ce que l'enveloppe (8) est une enveloppe en matière plastique SMD.
